# EUROPEAN PATENT APPLICATION

(11) **EP 4 350 028 A1**
(43) Date of publication of application: **10.04.2024**
(21) Application number: 22810167.1
(22) Date of filing: 26.03.2022
(51) Int. Cl.: C23C 14/10, C23C 14/35, C23C 14/08, C23C 14/58

(54) **METHOD FOR IMPROVING REDUCTION-RESISTANT PROPERTY OF CERAMIC PTC THERMOSENSITIVE ELEMENT**

(30) Priority: 27.05.2021 CN 202110585142
(71) Applicant: Jiangsu New Linzhi Electronic Technology Co., Ltd., Suqian, Jiangsu 223800 (CN)
(72) Inventor: FU, Qiuyun, Suqian, Jiangsu 223800 (CN); HE, Zhengan, Suqian, Jiangsu 223800 (CN); ZHOU, Dongxiang, Suqian, Jiangsu 223800 (CN); SHI, Yongfeng, Suqian, Jiangsu 223800 (CN)
(74) Representative: Ipey
(86) International application number: PCT/CN2022/083213
(87) International publication number: WO 2022/247433

(57) **Abstract**

A method for improving the resistance of a ceramic positive temperature coefficient (PTC) thermal element to reduction is provided, belonging to the technical field of preparation of electronic components. The ceramic PTC thermal element is a barium titanate based ceramic PTC thermal element. The method for improving the resistance to reduction includes: filling a material container body with the barium titanate based ceramic PTC thermal element; loading the material container body containing the barium titanate based ceramic PTC thermal element into a magnetron sputtering apparatus; sputtering, by the magnetron sputtering apparatus, an inorganic material as a target material onto the surface of the barium titanate based ceramic PTC thermal element when the material container body is in a rotating state, thereby forming a thin film layer of the inorganic material on the surface; and after the magnetron sputtering is completed, taking out the material container body containing the barium titanate based ceramic PTC thermal element with the thin film layer of the inorganic material combined on the surface, and performing high-temperature heat treatment. The resistance of the ceramic PTC thermal element to harsh environments is significantly improved and the ceramic PTC thermal element can meet the service requirements in environments containing reducing atmospheres. The process of the method is simple and meets the requirements of large-scale industrial production.

## Description

### Technical Field

The present disclosure belongs to the technical field of preparation of electronic components, and specifically relates to a method for improving the resistance of a ceramic positive temperature coefficient (PTC) thermal element to reduction.

### Background

The aforementioned ceramic PTC thermal element is a ceramic positive temperature coefficient ceramic thermal element (also known as "positive temperature coefficient ceramic thermal element", and referred to as "PTC element", hereinafter the same), which is generally prepared from a semiconductor ceramic material based on barium titanate. The characteristic of this type of thermal element is that when the temperature exceeds the Curie temperature, the room temperature resistance value of the thermal element will increase by several orders of magnitude, resulting in the so-called PTC effect. This PTC effect is originated from a grain boundary barrier. The height of the grain boundary barrier is closely related to the concentration of oxygen atoms adsorbed on a grain boundary. When a thermal element works in harsh environments such as reducing atmospheres for a long time, it will lead to oxygen loss at the grain boundary, resulting in performance failure of the element and even loss of the PTC effect. PTC thermal elements commonly used in the fields, such as new energy vehicles and air conditioning electric auxiliary heating, often work in such environments. On the one hand, the environments of workplaces (such as vehicles ) are harsh, and on the other hand, when PTC elements are assembled into heating components, they are usually bonded to metal radiators using organic adhesives. Such organic adhesives will emit a reducing atmosphere at high temperatures (greater than or equal to 200°C), which damages the PTC elements, and thus shortens the service life of the components.

The main reason why a PTC thermal element is susceptible to harsh environments is that the PTC thermal element is a polycrystalline ceramic material that has grain boundaries as well as a large number of micropores. Various adverse atmospheres can enter the grain boundaries via the micropores, thereby damaging the macroscopic electrical properties of the elements, for example, an automatic temperature control function is lost due to reduction.

Given the aforementioned situation, exploring a method for improving the resistance of a ceramic PTC thermal element to reduction is of positive significance, and the technical solution to be introduced below is put forward in this context.

### Summary

The task of the present disclosure is to provide a method for improving the resistance of a ceramic PTC thermal element to reduction. The process of the method is simple, and the ceramic PTC thermal element prepared by the method helps to prevent external harmful gases from invading the channels of ceramic grain boundaries via micropores on the ceramic surface, thereby improving the resistance to harsh environments, extending the service life, and meeting the service requirements in environments containing reducing atmospheres.

The task of the present disclosure is accomplished as follows: a method for improving the resistance of a ceramic PTC thermal element to reduction is provided, wherein the ceramic PTC thermal element is a barium titanate based ceramic PTC thermal element, and the method for improving the resistance to reduction includes: filling a material container body with the barium titanate based ceramic PTC thermal element; loading the material container body containing the barium titanate based ceramic PTC thermal element into a magnetron sputtering apparatus; sputtering, by the magnetron sputtering apparatus, an inorganic material as a target material onto the surface of the barium titanate based ceramic PTC thermal element when the material container body is in a rotating state, thereby forming a thin film layer of the inorganic material on the surface to prevent harmful gases from entering ceramic grain boundaries via micropores on the surface of the barium titanate based ceramic PTC thermal element; and after the magnetron sputtering is completed, taking out the material container body containing the barium titanate based ceramic PTC thermal element with the thin film layer of the inorganic material combined on the surface, and performing high-temperature heat treatment while controlling the temperature and time of the high-temperature heat treatment.

In a specific example of the present disclosure, the inorganic material is any one or a mixture of more than one of ZnO, Al₂O₃, SiO₂, ZrO₂, CaO, SrO, TiO₂, and BaO.

In another specific example of the present disclosure, when the inorganic material is a mixture of Al₂O₃, SiO₂ and TiO₂, the molar ratio of Al₂O₃: SiO₂: TiO₂ is 1:1:1.

In still another specific example of the present disclosure, the material container body is in a cylindrical shape, holes are formed at intervals around the material container body, an opening and closing door of the material container body is formed on the material container body, and pivot support shafts are formed at the central positions of two end faces of the material container body.

In yet another specific example of the present disclosure, the thin film layer of the inorganic material has a thickness of 0.1-3 µm.

In yet another specific example of the present disclosure, the material container body being in a rotating state refers to the material container body being in a rotating state at a rotational speed of 10-100 rpm.

In a more specific example of the present disclosure, an apparatus used for performing the high-temperature heat treatment is a high-temperature furnace.

In a still more specific example of the present disclosure, the controlling the temperature of the high-temperature heat treatment is to control the temperature of the high-temperature heat treatment to 300-500°C; and the controlling the time of the high-temperature heat treatment is to control the time of the high-temperature heat treatment to 30-60 min.

The technical effect of the technical solution provided by the present disclosure is that: the thin film layer of the inorganic material is formed on the surface of the barium titanate based ceramic PTC thermal element as a ceramic PTC thermal element by the magnetron sputtering method to prevent harmful gases from entering ceramic grain boundaries via micropores on the surface of the barium titanate based ceramic PTC thermal element, so the resistance of the ceramic PTC thermal element to harsh environments is significantly improved and the ceramic PTC thermal element can meet the service requirements in environments containing reducing atmospheres; and since the process used in the method is simple, the process can meet the requirements of large-scale industrial production.

### Brief Description of the Drawings

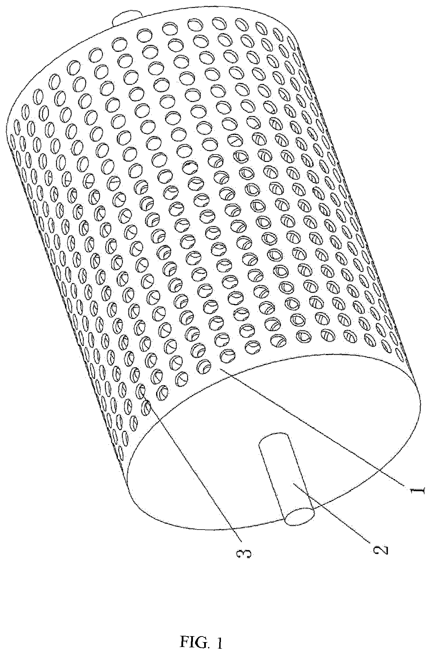

FIG. 1 is a schematic diagram of a material container used in the present disclosure.

In the figure: 1, material container body; 2, pivot support shaft; and 3, barium titanate based ceramic PTC thermal element.

### Detailed Description

### Example 1:

The present disclosure provides a method for improving the resistance of a ceramic PTC thermal element to reduction. The ceramic PTC thermal element is a barium titanate based ceramic PTC thermal element. The method for improving the resistance to reduction is described below. A cylindrical material container body 1 as shown in FIG. 1 is filled with the barium titanate based ceramic PTC thermal element 3. Holes are formed at intervals around the surface of the material container body 1. The size or diameter of the holes should be as large as possible as long as the barium titanate based ceramic PTC thermal element 3 cannot be thrown out, that is to say, the diameter of the holes is slightly smaller than the diameter of the barium titanate based ceramic PTC thermal element 3. An opening and closing door of the material container body is formed on the material container body 1, and pivot support shafts 2 are formed at the central positions of two ends of the material container body 1. Then, the cylindrical material container body 1 containing the barium titanate based ceramic PTC thermal element 3 is loaded into magnetron sputtering apparatus, i.e., a magnetron sputtering machine. When the cylindrical material container body 1 is in a rotating state of 100 rpm, that is, at a rotational speed of 100 rpm, an inorganic material as the target material is sputtered onto the surface of the barium titanate based ceramic PTC thermal element 3 by the magnetron sputtering apparatus, thereby forming a 0.1 µm thick thin film layer of the inorganic material on the surface to prevent harmful gases from entering ceramic grain boundaries via micropores on the surface of the barium titanate based ceramic PTC thermal element 3, that is, the thickness of the thin film layer of the inorganic material is 0.1 µm. After the magnetron sputtering is completed, the material container body 1 containing the barium titanate based ceramic PTC thermal element 3 with the thin film layer of the inorganic material combined on the surface is taken out and loaded into a high-temperature furnace for high-temperature heat treatment at 500°C for 30 min. In the present example, the inorganic material is a mixture of Al₂O₃, SiO₂ and TiO₂ mixed in a molar ratio of 1:1:1.

### Example 2:

The inorganic material is changed to TiO₂. The temperature and time of the high-temperature heat treatment are changed to 300°C and 60 min, respectively. The rotational speed of the cylindrical material container body 1 is changed to 10 rpm. The thickness of the thin film layer of the inorganic material is changed to 3 µm. The rest are the same as the description of Example 1.

### Example 3:

The inorganic material is changed to a mixture of ZnO, SiO₂, ZrO₂, SrO and BaO mixed in an equal molar ratio or random molar ratio. The temperature and time of the high-temperature heat treatment are changed to 400°C and 45 min, respectively. The rotational speed of the cylindrical material container body 1 is changed to 60 rpm. The thickness of the thin film layer of the inorganic material is changed to 1.6 µm. The rest are the same as the description of Example 1.

## Claims

1. A method for improving the resistance of a ceramic positive temperature coefficient (PTC) thermal element to reduction, the ceramic PTC thermal element being a barium titanate based ceramic PTC thermal element, wherein the method for improving the resistance to reduction comprises: filling a material container body with the barium titanate based ceramic PTC thermal element; loading the material container body containing the barium titanate based ceramic PTC thermal element into a magnetron sputtering apparatus; sputtering, by the magnetron sputtering apparatus, an inorganic material as a target material onto the surface of the barium titanate based ceramic PTC thermal element when the material container body is in a rotating state, thereby forming a thin film layer of the inorganic material on the surface for preventing harmful gases from entering ceramic grain boundaries via micropores on the surface of the barium titanate based ceramic PTC thermal element; and after the magnetron sputtering is completed, taking out the material container body containing the barium titanate based ceramic PTC thermal element with the thin film layer of the inorganic material combined on the surface, and performing high-temperature heat treatment while controlling the temperature and time of the high-temperature heat treatment.

2. The method for improving the resistance of a ceramic PTC thermal element to reduction according to claim 1, wherein the inorganic material is any one or a mixture of more than one of ZnO, Al₂O₃, SiO₂, ZrO₂, CaO, SrO, TiO₂, and BaO.

3. The method for improving the resistance of a ceramic PTC thermal element to reduction according to claim 2, wherein when the inorganic material is a mixture of Al₂O₃, SiO₂ and TiO₂, the molar ratio of Al₂O₃: SiO₂: TiO₂ is 1:1:1.

4. The method for improving the resistance of a ceramic PTC thermal element to reduction according to claim 1, wherein the material container body is in a cylindrical shape, holes are formed at intervals around the material container body, an opening and closing door of the material container body is formed on the material container body, and pivot support shafts are formed at the central positions of two end faces of the material container body.

5. The method for improving the resistance of a ceramic PTC thermal element to reduction according to claim 1, wherein the thin film layer of the inorganic material has a thickness of 0.1-3 µm.

6. The method for improving the resistance of a ceramic PTC thermal element to reduction according to claim 1, wherein the material container body being in a rotating state refers to the material container body being in a rotating state at a rotational speed of 10-100 rpm.

7. The method for improving the resistance of a ceramic PTC thermal element to reduction according to claim 1, wherein an apparatus used for performing the high-temperature heat treatment is a high-temperature furnace.

8. The method for improving the resistance of a ceramic PTC thermal element to reduction according to claim 1, wherein the controlling the temperature of the high-temperature heat treatment is to control the temperature of the high-temperature heat treatment to 300-500°C; and the controlling the time of the high-temperature heat treatment is to control the time of the high-temperature heat treatment to 30-60 min.
